(19) Europäisches Patentamt / European Patent Office / Office européen des brevets

(11) **EP 3 400 454 B1**

(12) **FASCICULE DE BREVET EUROPEEN**

(45) Date de publication et mention de la délivrance du brevet:
**10.06.2020 Bulletin 2020/24**

(21) Numéro de dépôt: **17700616.0**

(22) Date de dépôt: **05.01.2017**

(51) Int Cl.:
**G01R 33/34** *(2006.01)* **G01R 33/36** *(2006.01)*
**H01Q 1/52** *(2006.01)*

(86) Numéro de dépôt international:
**PCT/EP2017/050179**

(87) Numéro de publication internationale:
**WO 2017/118684 (13.07.2017 Gazette 2017/28)**

(54) **ANTENNE RÉSEAU, EN PARTICULIER POUR L'IMAGERIE PAR RÉSONANCE MAGNÉTIQUE NUCLÉAIRE, COMPRENANT DES RÉSONATEURS ÉLECTROMAGNÉTIQUES LINÉAIRES ET AU MOINS UN DISPOSITIF DE DÉCOUPLAGE**

ANTENNENANORDNUNG, INSBESONDERE ZUR MAGNETRESONANZBILDGEBUNG, MIT LINEAREN ELEKTROMAGNETISCHEN RESONATOREN UND MINDESTENS EINER ENTKOPPLUNGSVORRICHTUNG

ANTENNA ARRAY, IN PARTICULAR FOR MAGNETIC RESONANCE IMAGING, COMPRISING LINEAR ELECTROMAGNETIC RESONATORS AND AT LEAST ONE DECOUPLING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.01.2016 FR 1650147**

(43) Date de publication de la demande:
**14.11.2018 Bulletin 2018/46**

(73) Titulaires:
- **Commissariat à l'Énergie Atomique et aux Énergies Alternatives 75015 Paris (FR)**
- **Centre National de la Recherche Scientifique 75016 Paris (FR)**
- **Université d'Aix Marseille 13284 Marseille Cedex 07 (FR)**

(72) Inventeurs:
- **GEORGET, Elodie 13005 Marseille (FR)**
- **LUONG, Michel 92330 Sceaux (FR)**
- **VIGNAUD, Alexandre 75006 Paris (FR)**
- **GIACOMINI, Eric 61110 Bretoncelles (FR)**
- **CHAZEL, Edouard 91940 Les Ulis (FR)**
- **ABDEDDAIM, Redha 13008 Marseille (FR)**
- **ENOCH, Stefan 13013 Marseille (FR)**
- **TAYEB, Gérard 13013 Marseille (FR)**

(74) Mandataire: **Priori, Enrico Marks & Clerk France Immeuble "Visium" 22, avenue Aristide Briand 94117 Arcueil Cedex (FR)**

(56) Documents cités:
EP-A1- 2 757 385    EP-B1- 1 269 211
WO-A1-2011/098713    US-A1- 2011 121 834

- NIKOLAI I. AVDIEVICH ET AL: "Resonant inductive decoupling (RID) for transceiver arrays to compensate for both reactive and resistive components of the mutual impedance", NMR IN BIOMEDICINE., vol. 26, no. 11, 18 novembre 2013 (2013-11-18), pages 1547-1554, XP055317487, GB ISSN: 0952-3480, DOI: 10.1002/nbm.2989

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

- GEORGET ELODIE ET AL: "Stacked magnetic resonators for MRI RF coils decoupling", JOURNAL OF MAGNETIC RESONANCE, ACADEMIC PRESS, ORLANDO, FL, US, vol. 275, 21 November 2016 (2016-11-21), pages 11-18, XP029893573, ISSN: 1090-7807, DOI: 10.1016/J.JMR.2016.11.012

- P. J. FERRER ET AL: "Decorrelation of two closely spaced antennas with a metamaterial AMC surface", MICROWAVE AND OPTICAL TECHNOLOGY LETTERS, vol. 50, no. 5, 27 March 2008 (2008-03-27) , pages 1414-1417, XP055614338, US ISSN: 0895-2477, DOI: 10.1002/mop.23365

**Description**

L'invention porte sur une antenne réseau comprenant une pluralité de résonateurs électromagnétiques.

Plus particulièrement, l'invention s'applique à la réalisation d'antennes haute fréquence (en anglais « RF coil ») à voies multiples et à leur utilisation dans des appareils d'Imagerie par Résonance Magnétique (IRM, ou MRI de l'anglais « Magnetic Resonance Imaging ») pour l'homme ou l'animal. Plus particulièrement encore, elle s'applique à la réalisation d'antennes hautes fréquences pour l'IRM à haut champ, c'est-à-dire utilisant un champ magnétique statique $B_0$ d'intensité supérieure ou égale à 3 T (teslas). L'invention n'est cependant pas limitée à cette seule application.

En Imagerie par Résonance Magnétique, une antenne est utilisée en transmission pour générer un champ radiofréquence ayant une composante magnétique capable d'exciter les spins des noyaux des atomes, en particulier ceux de l'hydrogène (pour l'IRM dite du proton) au sein d'un échantillon placé dans l'antenne. Au cours du phénomène de relaxation, un signal radiofréquence de très faible amplitude est réémis par l'échantillon. Il peut alors être détecté soit par la même antenne commutée à ce moment-là sur une chaîne de réception munie d'amplificateurs à très faible bruit, soit par une autre antenne dédiée. Le champ magnétique statique, dit $B_0$ dans laquelle baigne l'échantillon détermine la fréquence du signal qui lui est proportionnelle. Ainsi, elle passe de 64 MHz à 128 MHz pour un champ $B_0$, de 1,5 et 3 teslas respectivement.

Pour les scanners IRM dits à haut champ, c'est-à-dire dont le champ $B_0$ dépasse 3 tesla, une antenne est généralement composée de plusieurs résonateurs mis en réseau afin d'obtenir, d'une part, une excitation uniforme à travers le procédé de transmission parallèle et, d'autre part, une meilleure sensibilité en réception qui améliore la qualité de l'image. Ces résonateurs émettent et reçoivent les signaux radiofréquences.

Le fonctionnement des antennes IRM à haut champ est caractérisé par une inhomogénéité des champs magnétiques radiofréquences émis ou perçus par un seul résonateur : $B_1^+$ en émission et $B_1^-$ en réception. La quantité $B_1^+$ correspond à la polarisation circulaire du champ magnétique tournant dans le même sens que les spins nucléaires utilisés pour l'imagerie. Par opposition, la quantité $B_1^-$ est la polarisation qui tourne en sens inverse et qui caractérise la sensibilité en réception. L'inhomogénéité des champs magnétiques est inhérente aux équations de l'électromagnétisme. Elle augmente avec la fréquence du signal et par conséquent avec le champ magnétique $B_0$. En émission, l'inhomogénéité de $B_1^+$ se traduit sur une image par l'apparition de zones d'ombre ou de contraste artificiel, difficiles à interpréter. Pour y remédier, une antenne réseau formée par une pluralité de résonateurs doit être utilisée, pour uniformiser soit directement $B_1^+$, soit l'angle de bascule. Cette compensation sera d'autant plus efficace que le nombre de résonateurs dans une antenne réseau sera élevé.

En réception, un plus grand nombre de résonateurs fournira un profil global de réception plus uniforme avec une augmentation du rapport signal sur bruit. Cette augmentation pourra être mise à profit pour accroître la résolution de l'image ou pour diminuer le temps d'acquisition en utilisant une méthode d'accélération qui utilise la sensibilité différentielle entre des résonateurs du fait de leur construction ou répartition autour de l'échantillon. En bref, l'amélioration des capacités et performances d'une antenne réseau doit passer par une augmentation du nombre de résonateurs. Or, cette approche n'est efficace que lorsque la taille de chaque résonateur est conservée ; en effet, le couplage entre les résonateurs et les spins nucléaires se fait en champ proche, et une diminution de la taille des résonateurs conduirait à une diminution de la profondeur de pénétration du champ haute fréquence. Par conséquent, l'augmentation du nombre de résonateur entraine nécessairement une diminution de la distance entre des résonateurs voisins qui conduit à un accroissement du couplage mutuel.

A rendement d'émission (ou sensibilité de réception) égal, l'accroissement du couplage mutuel s'observe par celui du coefficient de transmission du signal radiofréquence entre les terminaux (ou ports RF) des résonateurs voisins. Un couplage mutuel fort comporte quatre principaux inconvénients : (i) un réglage (accord en fréquence et une adaptation en impédance) difficile pour chaque résonateur car dépendant du réglage des résonateurs voisins ; (ii) une perte de rendement en émission car une partie de la puissance injectée est dissipée dans la charge des circulateurs des chaînes RF ou dans la résistance interne des amplificateurs de puissance qui alimentent les résonateurs voisins ; (iii) une augmentation du bruit à la réception car chaque résonateur reçoit le bruit propre des résonateurs voisins ; (iv) toujours en réception, une diminution de l'efficacité des algorithmes de reconstruction utilisés en IRM parallèle.

Le document [1] applique la théorie des circuits électriques à l'étude du couplage entre résonateurs. Il propose de découpler les résonateurs en les interconnectant au moyen d'un circuit réactif à éléments discrets. Cette solution présuppose une connaissance précise des caractéristiques des résonateurs et de leurs coefficients de couplage, ce qui est difficile - particulièrement en IRM où la présence de l'échantillon modifie de manière imprévisible ces caractéristiques. En outre, les éléments réactifs discrets sont difficiles à utiliser à haute fréquence, introduisent des pertes significatives et peuvent difficilement supporter les hautes tensions utilisées en IRM à transmission parallèle.

En pratique, il existe globalement deux catégories parmi les résonateurs utilisés en IRM : les résonateurs linéaires (en anglais « stripline », voir par exemple la référence [13]) et les résonateurs à boucle, ou circulaires (en anglais « loop »). En raison de la configuration géométrique, le couplage mutuel est plus faible entre des résonateurs linéaires pour un nombre donné dans un espace donné, comparé aux résonateurs à boucle. Pour cette raison, l'utilisation de résonateurs linéaires est préférée dans les applications d'IRM à haut champ. Par exemple, [6] décrit une antenne pour IRM à haut champ, en particulier pour acquérir des images de la tête, comprenant une pluralité de résonateurs linéaires agencés en cercle, de manière à former un cylindre creux.

Les solutions proposées pour découpler les résonateurs à boucle consistent soit à les superposer, soit placer un troisième résonateur circulaire entre deux résonateurs. Cette deuxième solution est proposée par [2].

Dans le cas des résonateurs linéaires, le découplage sera généralement réalisé à l'aide de condensateurs, voir [3] et [4]. Les inconvénients de cette approche sont de deux ordres. D'abord, cette solution repose sur la disponibilité des condensateurs, de préférence variables, capables de supporter des tensions élevées, de l'ordre de quelques kilovolts, et présentant un minimum de pertes. Ensuite, la présence des réactances parasites liées aux effets tridimensionnels à hautes fréquences, généralement au-delà de 300 MHz, complique largement la mise en œuvre de cette approche. Dans tous les cas, un dispositif de découplage doit s'efforcer de conserver au maximum les caractéristiques intrinsèques d'un résonateur, c'est-à-dire mesurées en absence de résonateurs voisins.

Une autre approche pour découpler deux résonateurs électromagnétiques consiste à les séparer par une structure passive périodique construite selon le principe des métamatériaux. Cette structure est disposée de telle sorte qu'une fois éclairée par une onde électromagnétique, elle génère un champ magnétique orthogonal à la direction de propagation de l'onde identifiable par le vecteur de Poynting ; pour cette raison, la structure est généralement appelée « conducteur (ou mur) magnétique ». La publication [5] décrit l'application d'un tel métamatériau au découplage de deux résonateurs linéaires de type monopole à 2,6 GHz ; les publications [7], [8], la demande internationale [9] et le brevet européen [10] concernent son application à des résonateurs de type boucle pour IRM. Les métamatériaux présentent l'inconvénient d'introduire des pertes élevées ; par ailleurs leur structure est périodique, ce qui limite les possibilités d'optimisation de l'efficacité de découplage en cours d'utilisation. En outre, la conception d'un dispositif de découplage à base de métamatériaux nécessite des simulations numériques qui sont très complexes, car un tel dispositif comprend nécessairement un nombre élevé d'objets (résonateurs élémentaires) de petite taille. On se heurte alors à des problèmes de capacité en mémoire vive et de temps de calcul.

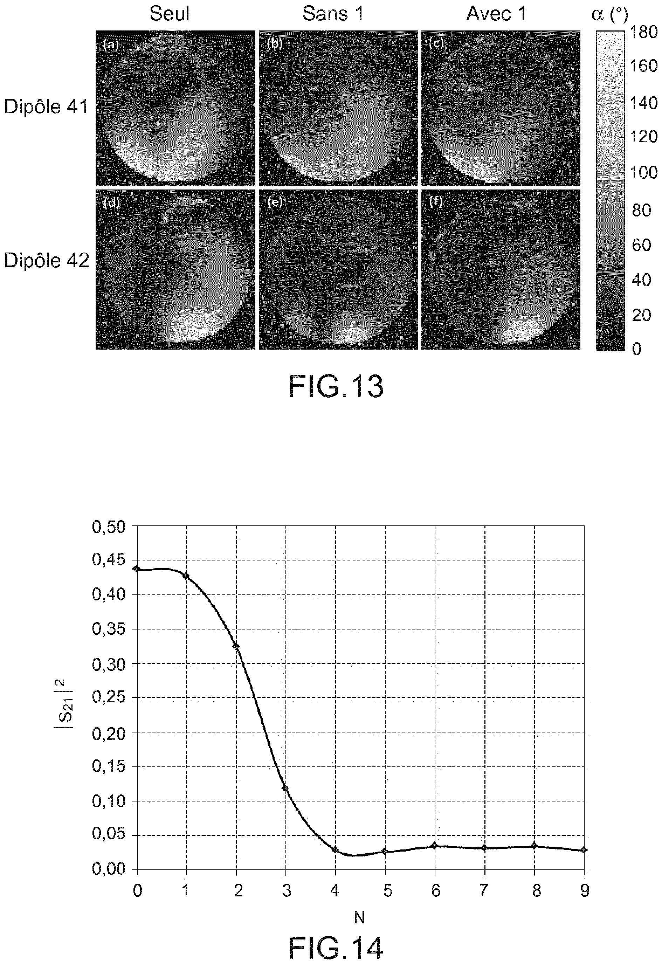

Les documents [11] et [12] décrivent des antennes réseaux pour IRM comprenant deux résonateurs à boucle coplanaires séparés par un espacement, et un résonateur de découplage - également du type à boucle - agencé dans cet espacement avec une orientation perpendiculaire à celle des deux résonateurs coplanaires, et donc au plan contenant ces derniers. Par contre, les métamatériaux proposés par [5] et [7] - [10] sont constitués de très petits résonateurs à boucle gisant dans des plans parallèles à celui qui contient les résonateurs à découpler. Cette technique de découplage, proposée pour des résonateurs à boucle, s'est révélée inadaptée aux résonateurs linéaires, comme cela sera discuté plus loin en référence à la figure 14.

L'invention vise à surmonter les inconvénients précités de l'art antérieur en proposant une antenne réseau selon la revendication 1. Une antenne réseau selon la revendication 1 comprend une pluralité de résonateurs électromagnétiques de type linéaire ayant des axes longitudinaux orientés parallèlement les uns aux autres et non disposés sur un axe commun, et au moins un dispositif de découplage agencé entre deux dits résonateurs électromagnétiques linéaires adjacents. Le dispositif de découplage comprend une pluralité de résonateurs de découplage du type à boucle, et plus précisément à boucle ouverte (« open loop » en anglais), c'est-à-dire comportant une boucle interrompue par un élément capacitif. Les résonateurs électromagnétiques de type boucle ouverte sont accordés à une fréquence située dans la bande passante des deux dits résonateurs électromagnétiques de type linéaire adjacents, et isolés électriquement de leur environnement. Chaque dit résonateur électromagnétique à boucle ouverte présentant une dimension caractéristique du même ordre de grandeur que la longueur des deux dits résonateurs linéaires. Ces résonateurs de découplage sont agencés dans une pluralité de plans, non nécessairement parallèles entre eux et sensiblement perpendiculaires, ou en tout cas non parallèles, au plan contenant deux résonateurs linéaires adjacents (ou, plus exactement, leurs axes longitudinaux) - et donc au vecteur de Poynting de l'onde électromagnétique rayonnée par chacun des deux résonateurs linéaires à découpler. Alors que l'utilisation d'un seul résonateur de découplage de ce type s'avère inefficace dans le cas d'une antenne basée sur des résonateurs linéaires, les présents inventeurs se sont rendu compte qu'un découplage très efficace peut être obtenu en utilisant plusieurs résonateurs, agencés sur un nombre limité de plans distincts. Ce dispositif de découplage introduit des pertes plus faible qu'un mur magnétique à métamatériau et, contrairement à ce dernier, permet une optimisation aisée du découplage en agissant sur la position et/ou l'orientation des résonateurs de découplage.

L'objet de la protection demandée est défini par le jeu de revendications joint.

D'autres caractéristiques, détails et avantages de l'invention ressortiront à la lecture de la description faite en référence aux dessins annexés donnés à titre d'exemple et qui représentent, respectivement :

- Les figures 1a à 1e, cinq agencements possibles de résonateurs de découplage sur des supports planaires ;
- La figure 2, deux supports planaires de résonateurs de découplage reliés par un intercalaire rigide ;
- Les figures 3a à 3e, 4a, 4b, 5a et 5b, différentes configurations d'un dispositif de découplage selon des modes de réalisation respectifs de l'invention ;
- La figure 6, un exemple de résonateur de découplage pour une antenne IRM à 7 T ;
- Les figures 7 et 16, deux photographies de deux prototypes d'antennes selon des modes de réalisation respectifs de l'invention ;
- Les figures 8a et 8b, un prototype d'antenne IRM selon un mode de réalisation de l'invention, avec à son intérieur un fantôme simulant une tête ;
- Les figures 9 à 12, 14, 15 et 17 des graphiques illustrant l'effet technique de l'invention ;
- Les figures 13a à 13f des cartes des angles de bascule des spins nucléaires du fantôme des figures 8a - 8b ; et
- Les figures 18a et 18b des cartes de champ magnétique illustrant le fonctionnement d'un dispositif de découplage selon l'invention ; et
- La figure 19, la structure d'un prototype d'antenne selon un autre mode de réalisation de l'invention.

Les principes à la base de l'invention sont les suivants.

Entre deux résonateurs émetteurs et/ou récepteurs d'une antenne IRM, le couplage mutuel est généralement le résultat de la circulation du champ magnétique créé par l'excitation du premier, autour du second ; cette circulation se faisant sur des contours fermés englobant le second résonateur. Ainsi, le passage d'un courant électrique 1 dans le premier résonateur induit un courant I' tel que |I'|<|I| dans le second résonateur en vertu de la loi de Lenz. Le rapport I'/I détermine la force du couplage mutuel. Lorsqu'un dispositif de découplage selon l'invention est placé dans le champ électromagnétique rayonné par le premier résonateur, il créé à son tour, toujours en vertu de la loi de Lenz un champ magnétique dont la circulation sur des contours fermés englobant le second résonateur génère un courant I" dans ce dernier de sens opposé à l'. Le découplage idéal est obtenu lorsque la somme algébrique des courant I" et l' est nulle. Cette condition nécessite une certaine distribution dans l'espace des champs magnétiques associés à la fois aux résonateurs à découpler et au dispositif de découplage lui-même. La mise en œuvre d'une pluralité de résonateurs, agencés dans des plans distincts, dans le dispositif de découplage, permet de synthétiser une distribution particulière du champ magnétique afin de moduler l'amplitude du courant I". Cette modulation permet d'optimiser expérimentalement et facilement le découplage au cours de la mise au point de l'antenne réseau.

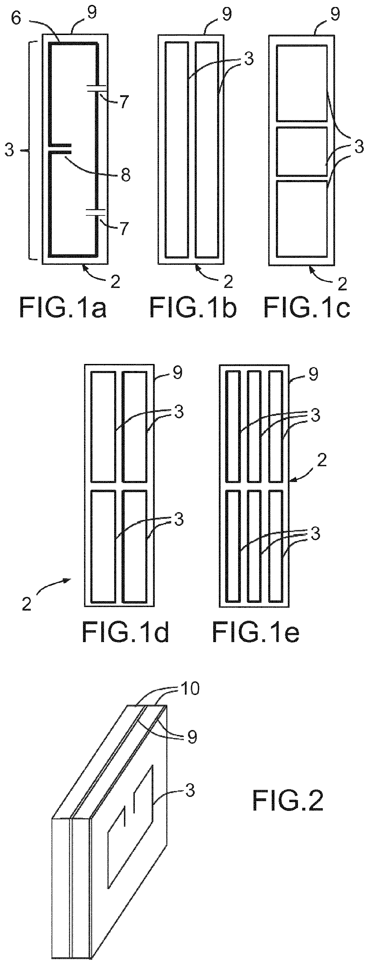

Un dispositif de découplage 1 selon l'invention est constitué par le regroupement de motifs 2 identiques. Chaque motif, de forme planaire, comporte une pluralité de résonateurs de découplage 3, du type à boucle ouverte, dont le nombre dans chacune des deux directions du plan sera optimisé en fonction de la configuration des résonateurs à découpler. Les figures 1a à 1c montrent des motifs 2 comprenant 1 (fig. 1a), 2 (fig. 1b), 3 (fig. 1c), 4 (fig. 1d) et 6 (fig. 1e) résonateurs de découplage chacun.

Ces résonateurs de découplage 3 sont dépourvus de connexion électrique directe entre eux ou avec un autre élément quelconque de l'antenne.

Selon un mode de réalisation préféré de l'invention, chaque résonateur 3 est formé par une piste conductrice 6, par exemple en cuivre, qui se referme sur un ou plusieurs condensateurs discrets 7 et/ou à effets répartis 8. En raison de l'absence de connexion électrique directe, les condensateurs discrets 7 ne sont pas soumis à des tensions électriques élevées. Les segments de piste en regard et constituant les condensateurs à effets répartis 8 peuvent être rognés pour ajuster la fréquence de résonance du résonateur 3. Cette fréquence doit être proche de la fréquence de fonctionnement des résonateurs à découpler. Sa valeur optimale peut être prédéterminée par la simulation numérique ou de manière expérimentale (heuristique) : elle doit se situer dans la bande passante des résonateurs à découpler. Par ailleurs, chaque résonateur de découplage présente une longueur caractéristique (par exemple, sa plus grande dimension linéaire - son plus grand coté dans le cas d'une géométrie rectangulaire) du même ordre de grandeur que la longueur de chacun des résonateurs linéaires à découpler 4. On entend par cela que la longueur caractéristique $L_D$ de chaque résonateur de découplage est comprise entre 0,1 et 10 fois, et de préférence entre 0,2 et 2 fois, la longueur Lr des résonateurs à découpler 4. Avantageusement, les résonateurs de découplage 3 présentent une forme allongée (par exemple rectangulaire, ou elliptique) avec un plus grand côté (ou un plus grand axe dans le cas elliptique) orienté parallèlement à l'axe longitudinal L des résonateurs linéaires à découpler 4.

Les résonateurs de découplage 3 peuvent être réalisés selon la technique des circuits imprimés sur un support 9 rigide, typiquement le stratifié Rogers 4350 d'épaisseur 0,8 mm ou souple, typiquement un film polyamide de 50 microns. Un motif est ainsi constitué d'un support 9 sur lequel sont disposés un ou plusieurs résonateurs 3. Dans le cas d'un support souple, un intercalaire rigide 10, par exemple en mousse, doit être ajouté de part et d'autre d'un motif ; un intercalaire 10 peut aussi servir à relier deux motifs entre eux (figure 2). Les matériaux constitutifs du support 9 et de l'intercalaire 10 doivent présenter un minimum de perte diélectrique à la fréquence de fonctionnement.

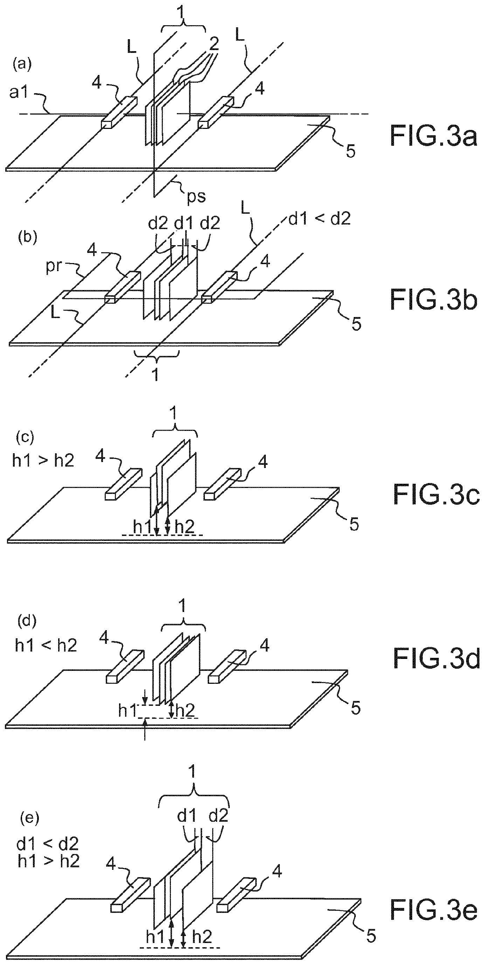

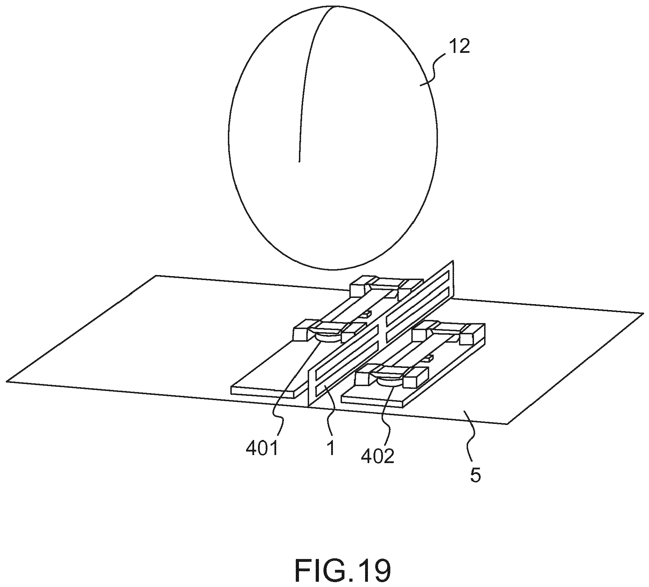

Comme le montrent les figures 3a à 5b, une antenne réseau selon l'invention comprend au moins deux résonateurs à découpler 4, de type linéaire. Ces résonateurs 4 sont parallèles entre eux, c'est-à-dire qu'ils présentent des axes longitudinaux L parallèles entre eux. Dans les modes de réalisation des figures 3a à 5b, ils sont disposés côte à côte, décalés dans une direction perpendiculaire à leur direction longitudinale commune (une autre configuration possible est illustrée sur la figure 19 et sera discutée plus loin). Ils sont séparés d'une distance qui est généralement très faible par rapport à la longueur d'onde dans l'air (λ) du rayonnement électromagnétique qu'ils émettent. Par exemple, cette distance peut être comprise entre 1% et 15% de λ. Leur longueur, par contre, est généralement proche de λ/4, et typiquement comprise entre λ/8 et λ et de préférence entre λ/8 et λ/2.

De préférence, ces résonateurs 4 sont agencés au-dessus d'un plan de masse, ou blindage, 5. Le dispositif de découplage 1 est agencé entre les deux résonateurs 4 à découpler, du même côté du plan de masse 5 que ceux-ci.

Les différents motifs 2 du dispositif de découplage 1, dont le nombre est généralement compris entre 2 et 10 et de préférence entre 3 et 6, sont agencés dans des plans distincts. Dans la suite, dans un souci de simplicité, on confondra un motif 2 et son plan, qui sera désigné également par la référence 2. Ces plans peuvent être parallèles entre eux et perpendiculaires au plan (référence pr sur la figure 3b) qui contient les axes longitudinaux L des résonateurs 4. Plus particulièrement, dans le cas considéré ici, où les résonateurs à découpler 4 sont agencés côte à côté (sans décalage longitudinal), les plans des motifs 2 sont aussi perpendiculaires à l'axe (référence a1 sur la figure 3a) qui unit les centres des résonateurs à découpler, cet axe étant par ailleurs parallèle au vecteur de Poynting du champ électromagnétique émis par chacun des résonateurs 4. Plus généralement, les plans 2 peuvent être inclinés par rapport au plan pr, formant avec ce dernier un angle qui est généralement compris entre 10° et 170° et de préférence entre 45° et 135°. Dans ce cas, il n'est pas nécessaire que tous les plans 2 soient parallèles entre eux.

Les figures 3a à 3e illustrent différents modes de réalisation dans lesquels les plans des motifs sont parallèles entre eux et perpendiculaires au plan pr et à l'axe a1.

Dans le cas de la figure 3a, quatre motifs 2 sont agencés perpendiculairement au plan pr et à l'axe a1 ; ils sont équidistants entre eux et situés à une même hauteur par rapport au plan de masse 5, qui est parallèle au plan pr.

Dans le cas de la figure 3b, quatre motifs 2 sont agencés perpendiculairement au plan pr et à l'axe a1, à une même hauteur par rapport au plan de masse 5, qui est parallèle au plan pr. Ils ne sont cependant pas équidistants: les deux motifs du milieu sont séparés d'une distance d1, inférieure à celle (d2) qui les sépare des motifs d'extrémité.

Dans le cas de la figure 3c, quatre motifs 2 sont agencés perpendiculairement au plan pr et à l'axe a1, avec un même espacement. Les deux motifs du milieu présentent une distance du plan de masse 5 (parallèle au plan pr), notée h1, qui est supérieure à celle (h2) des deux motifs d'extrémité.

Le cas de la figure 3d se différencie de celui de la figure 3c uniquement en ce que h1<h2.

Le cas de la figure 3e se différencie de celui de la figure 3c uniquement en ce que les deux motifs du milieu sont séparés d'une distance d1, inférieure à celle (d2) qui les sépare des motifs d'extrémité.

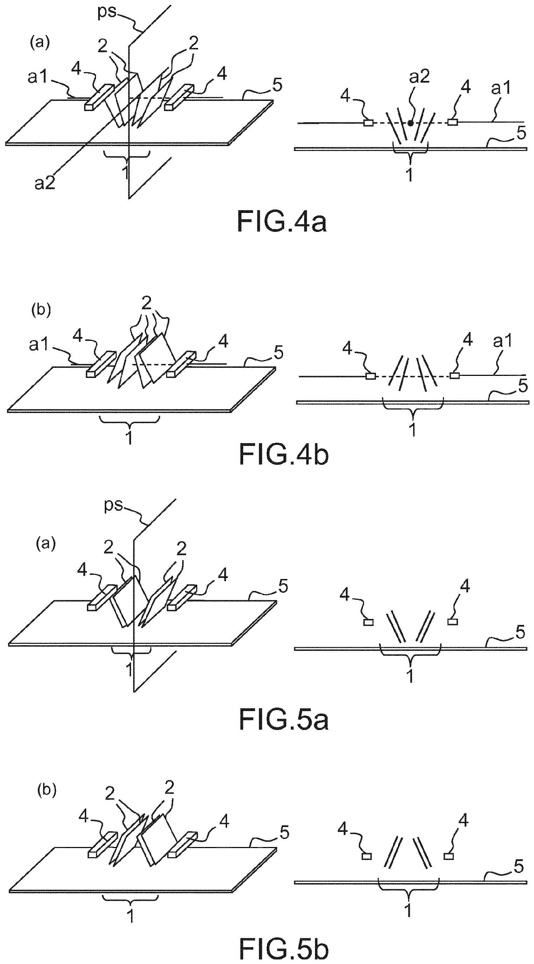

La figure 4a montre une vue en perspective (partie gauche de la figure) et en coupe (partie droite) d'un mode de réalisation dans lequel les quatre motifs 2 ne sont ni perpendiculaires à l'axe a1 ou au plan pr, ni parallèles entre eux, mais sont ouverts « en livre » avec les côtés les plus espacés orientés vers le haut (à l'opposé du plan de masse 5). Par rapport aux configurations des figures 1a - 1e, on peut considérer que les plans ont tourné autour d'un axe a2 (représenté uniquement sur la figure 4a) parallèle aux axes longitudinaux L des résonateurs 4 à découpler, et donc parallèle au plan de masse 5 et perpendiculaire au plan pr et à l'axe a1. La figure 4b montre la configuration inverse, dans laquelle les côtés les plus espacés des motifs 2 sont orientés vers le plan de masse 5.

Les configurations des figures 5a et 5b se différencient de celles des figures 4a et 4b en ce que les motifs sont parallèles deux à deux. Ils peuvent d'ailleurs être reliés, deux à deux, à des intercalaires rigides 10 (cf. la figure 2).

Dans tous les modes de réalisation illustrés dans les figures 3a à 5b, les motifs 2 et les résonateurs à découpler 4 sont agencés de manière symétrique par rapport à un plan ps, perpendiculaire au plan pr et à l'axe a1. Ce plan ps est illustré schématiquement sur les seules figures 3a, 4a et 5a.

Ces configurations sont données uniquement à titre d'exemples non limitatifs. D'autres configurations sont possibles, par exemple non symétriques par rapport au plan ps. L'objet de la protection demandée est défini par le jeu de revendications joint.

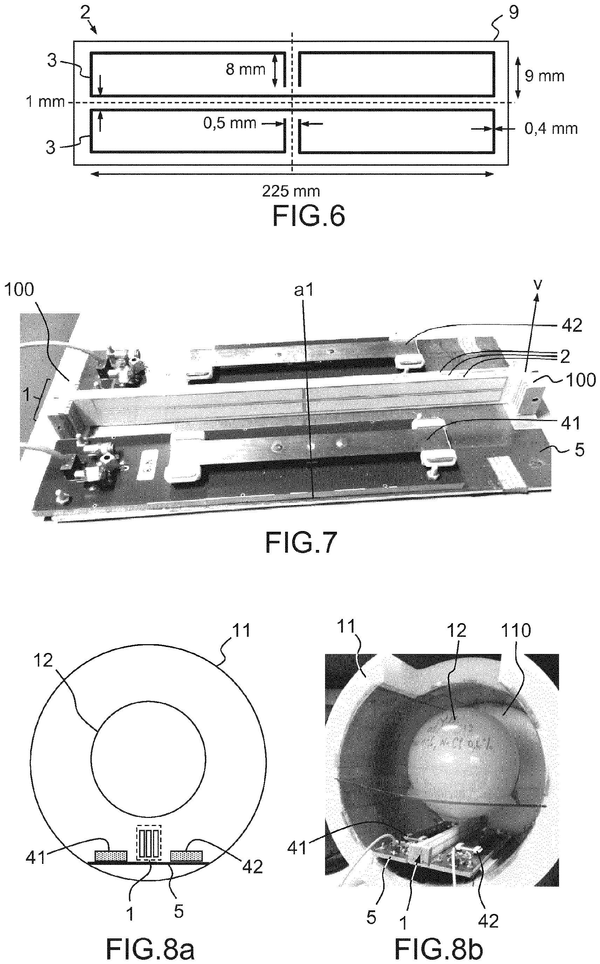

De manière avantageuse, la position des motifs 2 par rapport aux antennes peut être ajustée facilement, de manière à optimiser l'effet de découplage. Cet ajustement peut consister en un déplacement et/ou une rotation du dispositif de découplage 1 dans son ensemble, mais de préférence au moins certains motifs 2 pourront être déplacés, ou tournés, indépendamment des autres. Cela sera décrit plus loin en référence à la figure 7.

Tous les paramètres de l'invention : forme et nombre des résonateurs de découplage 3, leur agencement relatif, le positionnement du dispositif 1 dans son ensemble, etc. peuvent être déterminés soit par calcul numérique avec des codes de simulation commerciaux, soit par une approche heuristique.

Une preuve de concept de l'invention est fournie pour une antenne simplifiée fonctionnant dans un scanner IRM à 7 T (teslas) pour le proton. Pour cela, un empilement de trois motifs 2 a été utilisé ; la figure 6 montre la structure et les dimensions de chacun de ces motifs 2, comprenant deux résonateurs de découplage 3. Le dispositif 1 ainsi formé présente les dimensions suivantes : 19 mm x 225 mm x 5,7 mm. Dans le scanner (appareil d'IRM) utilisé pour la démonstration expérimentale, la fréquence de Larmor du proton est de 297,2 MHz. Ces motifs ainsi dimensionnés sont utilisés pour découpler des résonateurs linéaires 4, dénommés aussi « dipôles » - voir par exemple [6].

La figure 7 montre le dispositif 1 agencés entre les deux dipôles 41, 42. Des supports rainurés 100 aux extrémités du dispositif 1 permettent de maintenir en place les motifs 2. En choisissant la rainure de chaque support 100 dans laquelle les extrémités d'un motif 2 sont insérées on peut régler (de manière discrète) sa position le long de l'axe a1. Un motif 2 peut aussi être glissé le long des rainures de manière à ajuster sa position verticale (direction « v ») et donc sa distance du plan de masse 5. Il serait également possible de prévoir des rainures obliques de manière à permettre un ajustement (discret) de l'inclinaison des motifs 2 par rapport au plan pr (non représenté) et à l'axe a1 ; dans le cas de la figure 7, cependant, ces rainures obliques ne sont pas présentes et les motifs 2 sont perpendiculaires à pr et à a1. Il n'est pas difficile d'envisager d'autres systèmes mécaniques de fixation des motifs permettent l'ajustement de leur position selon au moins certains de ces degrés de liberté (position le long de a1 ou, plus généralement, d'une direction perpendiculaire aux axes longitudinaux L des résonateurs 4 ; position selon la direction v ; inclinaison par rapport au plan pr).

L'ensemble constitué par les deux dipôles 41, 42, le dispositif de découplage 1 et le plan de masse 5 est positionné dans une coque blindée 11 définissant une cavité 110 contenant un fantôme de test 12 sphérique de 78 mm de rayon, rempli d'un gel d'agar dont les caractéristiques électriques sont proches de celles d'un tissu organique : constante diélectrique = 74,2 ; conductivité électrique = 0,87 S/m (voir le schéma de la figure 8a et la photographie de la figure 8b). Cet ensemble forme une antenne simplifiée ; une véritable antenne réseau en IRM pour la tête humaine comporte généralement au moins 8 dipôles entourant la cavité 110.

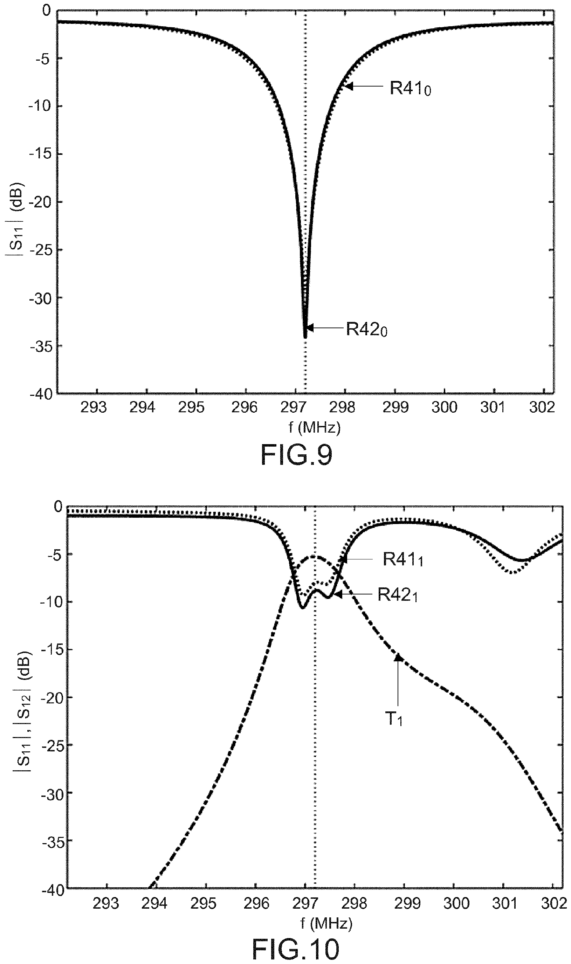

Les courbes de la figure 9 montrent les coefficients de réflexion (module du paramètre $S_{11}$ de la matrice de répartition - « scattering matrix » en anglais) de chaque dipôle placé seul dans la coque blindée 11, sans son voisin, en fonction de la fréquence f. La courbe $R41_0$ en trait pointillé correspond au dipôle 41, la courbe $R42_0$ en trait continu au dipôle 42. Les dipôles étant nominalement identiques, et isolés, les deux courbes sont très proches

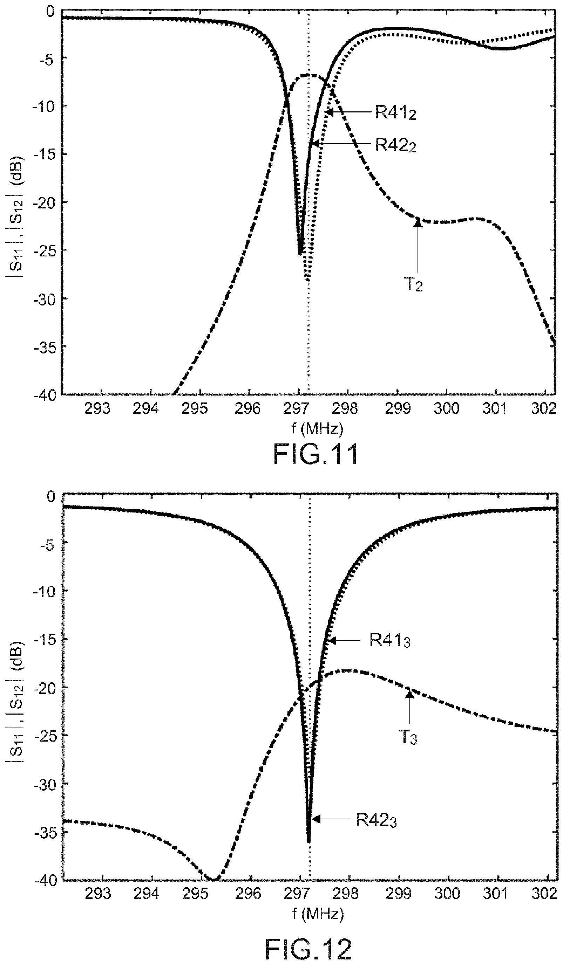

Les dipôles 41 et 42 sont très bien adaptés en impédance, les coefficients de réflexion sont à -29 dB et -34 dB pour chacun des dipôles. Quand ces derniers sont tous deux positionnés à 7,6 cm l'un de l'autre, de centre à centre, dans la coque 11 sans le dispositif de découplage 1, les coefficients de réflexion qui étaient autour de -30 dB dans le cas des dipôles pris isolément, passent à une valeur autour de -8 dB à la fréquence de Larmor (figure 10, courbes $R41_1$, $R42_1$). En plus, le couplage mutuel $|S_{12}|$, c'est-à-dire la transmission (courbe $T_1$) entre les deux dipôles s'élève -5 dB, ce qui veut dire que plus du quart de la puissance disponible en transmission sur un des dipôles est perdu dans la charge dissipative du circulateur auquel chaque dipôle est connecté. Le fort couplage entre les deux dipôles 41, 42 fait apparaître deux résonances autour de la fréquence de Larmor. En pratique, un circuit passif composé de condensateurs et d'inductances permet de régler à nouveau chaque dipôle 41, 42 pour minimiser la puissance réfléchie à la fréquence de Larmor. Par contre, le couplage entre les éléments rayonnants reste très élevé, effectivement le coefficient de transmission est de -7 dB (figure 11, courbes $R41_1$, $R41_2$, $T_2$). L'ajout du dispositif 1 de découplage permet d'agir simultanément sur les coefficients de réflexion et de transmission. Le coefficient de réflexion $|S_{11}|$ de chaque dipôle 41, 42 n'est que très peu modifié par rapport au réglage réalisé quand il est pris isolément et le coefficient de transmission $|S_{12}|$ entre les deux dipôles (4) est beaucoup moins important (figure 12, courbes $R41_3$, $R42_3$, $T_3$), il passe de -7 dB à - 20 dB. Un gain 13 dB dans l'isolation est ainsi observé. Il faut noter que ces performances sont obtenues pour 3 motifs dans le dispositif de découplage, avec ce dernier placé 1 mm au-dessus du blindage 5. Si le nombre de motifs passait à 2 au lieu de 3, le gain observé ne serait plus que de 7 dB. De la même manière, si le dispositif 1 était surélevé de 3 mm par rapport au blindage 5, une baisse similaire du gain en isolation serait observée. Inversement, si la position du dispositif 1 en hauteur par rapport aux dipôles 41, 42 n'était pas limitée par le plancher que constitue le blindage 5, un gain supérieur en isolation serait possible.

L'efficacité du découplage étant démontrée par la mesure de la transmission entre les deux dipôles 41, 42, il reste à vérifier que le champ magnétique rayonné par chacun de ces dipôles en présence du dispositif de découplage 1 reste comparable à celui qu'il rayonnerait s'il avait été seul dans l'antenne simplifiée. En IRM, la composante de polarisation circulaire du champ magnétique qui tourne dans le même sens que les spins des protons peut être mesurée indirectement. En effet, cette composante est proportionnelle à l'angle de bascule des spins ; certaines séquences dédiées permettent de mesurer cet angle.

La figure 13 montre les angles de bascule $\alpha$ des spins des protons au centre du fantôme dans le plan perpendiculaire à la dimension la plus grande du dispositif de découplage dans les 3 configurations pertinentes : dipôles pris isolément ((a) et (d)), dipôles côte à côte sans le dispositif de découplage 1 ((b) et (e)), dipôles côte à côte avec le dispositif de découplage 1 ((c) et (f)). Les zones striées correspondent à de faibles angles de bascule où les artéfacts de mesure sont plus importants. La comparaison montre que le dispositif de découplage 1 remplit bien son rôle, c'est-à-dire que les angles associés au champ rayonné (c) et (f) se rapprochent beaucoup plus de (a) et (d) alors que les angles (b) et (e) en diffèrent assez nettement.

Il est important de souligner que l'efficacité du découplage, mesurée par le coefficient de transmission en puissance $|S21|^2$ entre les deux résonateurs 41 et 42, varie de manière non-linéaire et non évidente par rapport au nombre N de motifs du dispositif de découplage. Cela est illustré par la figure 14 ; on peut vérifier que l'isolation est quasiment nulle si un seul motif est utilisé, augmente très sensiblement à partir de deux - et surtout trois - motifs, puis n'augmente plus (voire diminue légèrement) au-delà de quatre motifs. Bien entendu, le nombre optimum de motifs peut varier en fonction de la configuration considérée, mais est généralement compris entre 3 et 6.

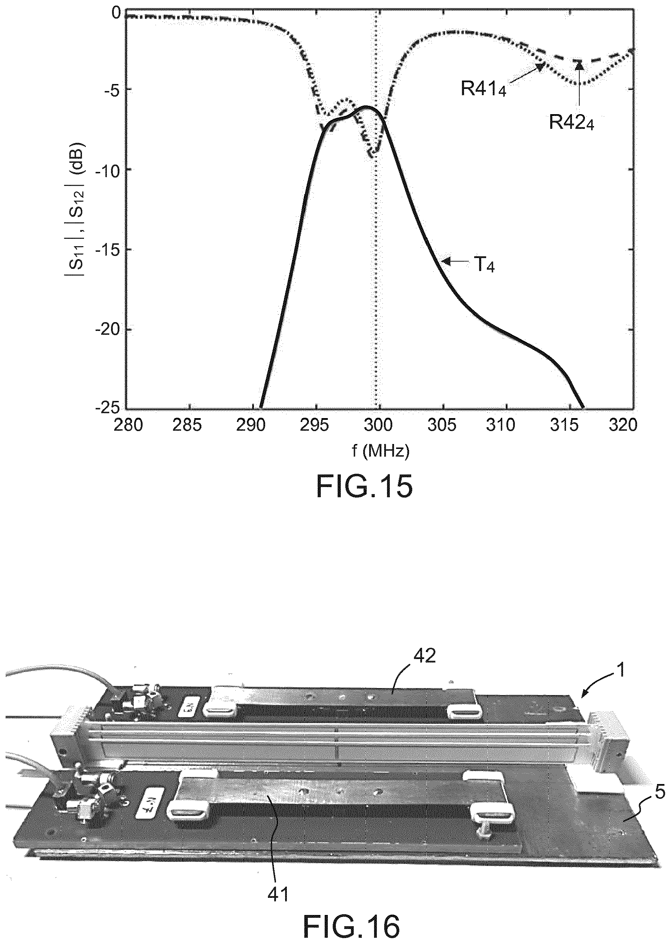

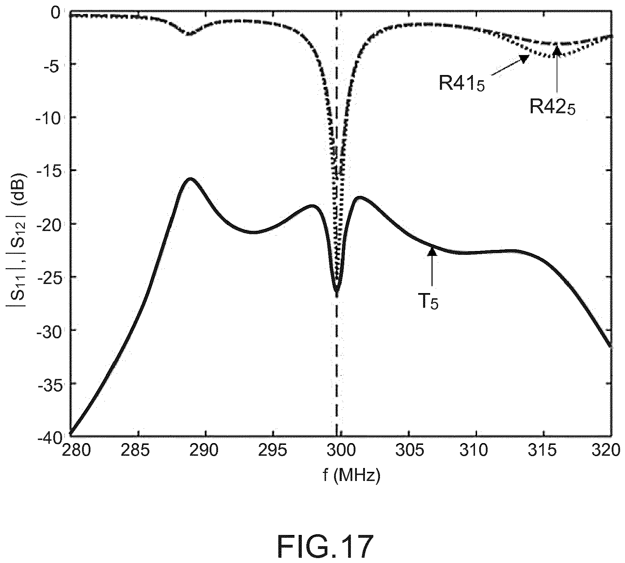

Une autre illustration des propriétés particulières conférées par la disposition optimale dans l'espace d'une pluralité de motifs 2 a été obtenue en considérant un motif 2 plus simple ne comportant qu'un seul résonateur de découplage 3, comme représenté sur la figure 1a. Ce résonateur possède la forme et les dimensions indiquées sur la figure 6 à cette différence près que le second résonateur en symétrie miroir par rapport au premier a été enlevé. Les courbes de réflexions et de transmission obtenues avec un seul motif sont représentées sur la figure 15 (courbes $R41_4$, $R42_4$, $T_4$). La mesure a été réalisée dans la configuration de la figure 8, c'est-à-dire en présence du fantôme 12 et à l'intérieur de la coque 11. L'efficacité de découplage est très faible avec un seul motif. Les courbes $R41_4$, $R42_4$, $T_4$ sont très similaires aux courbes $R41_1$, $R42_1$, $T_1$ de la figure 10, obtenues sans le dispositif de découplage 1. En revanche, le même motif 2 agencé en nombre de cinq selon une configuration dérivée de la figure 3c et illustrée par la figure 16 (les deux motifs les plus proches du résonateur 42 ne sont pas visibles), forme un dispositif 1 particulièrement efficace, comme le montrent les courbes $R41_5$, $R42_5$, $T_5$ de la figure 17.

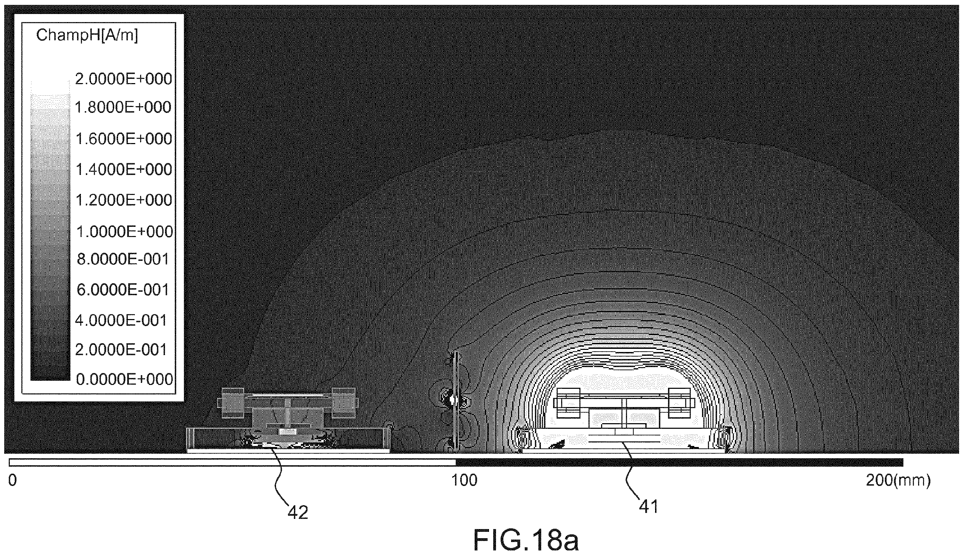

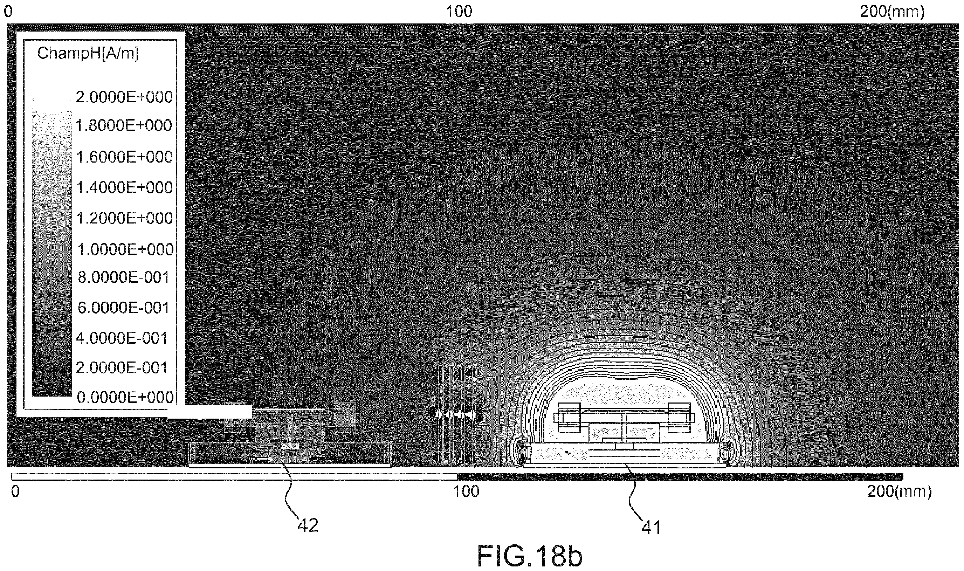

Des simulations numériques permettent de montrer que l'efficacité du dispositif de découplage selon l'invention est obtenue à travers une redistribution dans l'espace du champ magnétique rayonné par un résonateur 41, qui peut être vue comme un effet de canalisation. Une telle redistribution n'est rendue possible que par la présence d'au moins deux motifs 2. Les figure 18a/18b illustrent cet effet de canalisation lorsque 4 motifs 2 (figure 18b) sont utilisés à la place d'un seul (figure 18a) ; dans les deux cas, seul le résonateur 41 est alimenté, et on s'intéresse au champ magnétique généré par ce dernier au niveau du résonateur 42. Ces figures représentent le module et les lignes iso-valeurs du champ magnétique H (en A/m) dans un plan orthogonal à la direction principale de résonateurs linéaires 41 et 42, et passant à 15 mm des condensateurs à effets répartis 8 du motif 2 pour se soustraire aux effets très locaux de ces derniers sur la redistribution du champ. Le champ représenté est calculé par le logiciel Ansys HFSS basé sur la méthode des éléments finis avec une modélisation aussi fidèle que possible par rapport aux objets utilisés dans la preuve expérimentale. Il est ainsi possible d'y observer d'une part une variation rapide du champ magnétique dans les différentes directions du plan et d'autre part l'apparition d'un « canal » de champ magnétique d'autant plus long que le nombre de motifs est élevé. En l'absence de cet effet de canalisation, le champ magnétique généré par les résonateurs de découplage 3 sera trop faible pour générer dans le résonateur 42 un courant induit I" suffisant pour annuler le courant I' induit directement par le champ magnétique émis par le résonateur 41.

L'invention a été décrite en référence à un certain nombre de modes de réalisation, mais des variantes sont possibles, l'objet de la protection demandée étant défini par le jeu de revendications joint. Par exemple, il n'est pas indispensable que les résonateurs de découplages soient strictement identiques entre eux. De même, les résonateurs linéaires à découpler peuvent être différents les uns des autres. En outre, il est possible que les résonateurs linéaires à découpler soient décalés le long de leurs axes longitudinaux L, qui demeurent parallèles ; il faut alors que le dispositif de découplage s'étende sur la longueur cumulée des deux résonateurs linéaires à découpler. Cette configuration est représentée sur la figure 19, où les résonateurs décalés axialement sont identifiés par les références 401 et 402. On remarque que, dans ce cas, l'orientation spatiale des motifs de découplage est définie par rapport au plan pr et non par rapport à l'axe a1, qui devient moins pertinent.

En outre, le plan de masse peut ne pas être parallèle au plan pr ; il peut même être remplacé par une surface de masse non plane, par exemple globalement concave par rapport aux résonateurs 4 et obtenue par l'extrusion d'un profil le long de l'axe L.

Références

[1] Lee, R. F. et al. (2002), Coupling and decoupling theory and its application to the MRI phased array. Magnetic Resonance Medicine, 48: 203-213.

[2] US 2013/0271144 A1: Avdievich, N. I. et al. (2013), Magnetic-resonance transceiver-phased array that compensates for reactive and resistive components of mutual impedance between array elements and circuit and method thereof.

[3] US 2011/0312499 A1: Vaughan, J. T. et al. (2011), Coil Element Decoupling for MRI.

[4] Yan, X., & Zhang, X. (2015). Decoupling and matching network for monopole antenna arrays in ultrahigh field MRI, Quantitative imaging in medicine and surgery, 5(4), 546-551.

[5] Ferrer, P. J. et al. (2008), Decorrelation of two closely spaced antennas with a metamaterial AMC surface, Microwave and optical technology letters, 50(5): 1414-1417.

[6] WO 2011/098713 A1 : Ferrand, G. et al. (2011) Résonateur linéaire d'une antenne haute fréquence pour appareil d'imagerie par résonance magnétique nucléaire.

[7] Connel I. R. O. et al. (2015) MRI RF Array Decoupling Method With Magnetic Wall Distributed Filters, IEEE Transactions on Medical Imaging, 34(4): 825-835.

[8] Connel I. R. O. et al. (2015) Design of a Parallel Transmit Head Coil at 7T With Magnetic Wall Distributed Filters, IEEE Transactions on Médical Imaging, 34(4): 836-865.

[9] WO 2014/109757 A1: Menon R. et al. (2014) System and method for decoupling magnetic resonance imaging radio frequency coils with a modular magnetic wall.

[10] EP 1 269 211 B1: Young I.R. et al. (2007) Magnetic resonance imaging apparatus with means to screen RF fields.

[11] Y. Soutome et al. Vertical Loop Decoupling Method for Gapped Phased-Array Coils Proc. Intl. Soc. Mag. Reson. Med. 19 (2011) 1859.

[12] US 2011/0121834 A1 : Y. Soutome et al. «High-frequency coil and magnetic resonance device » (2011).

[13] EP 2 757 385 A1 R. Yeun-chul et al. « Radio frequency coil for magnetic resonance » (2014).

## Revendications

**1.** Antenne réseau comprenant une pluralité de résonateurs électromagnétiques linéaires (4) ayant des axes longitudinaux (L) orientés parallèlement les uns aux autres et non disposés sur un axe commun, et au moins un dispositif de découplage (1) agencé entre deux dits résonateurs électromagnétiques linéaires adjacents, ledit dispositif de découplage comprenant une pluralité de résonateurs électromagnétiques de type boucle ouverte (3), accordés à une fréquence située dans la bande passante des deux dits résonateurs électromagnétiques de type linéaire adjacents, et isolés électriquement de leur environnement, chaque dit résonateur électromagnétique à boucle ouverte présentant une dimension caractéristique du même ordre de grandeur que la longueur des deux dits résonateurs linéaires adjacents, **caractérisée en ce que** la pluralité de résonateur électromagnétiques de type boucle ouverte sons agencés dans une pluralité de plans respectifs (2) non parallèles à un plan (pr) contenant les axes longitudinaux des deux dits résonateurs électromagnétiques linéaires.

**2.** Antenne réseau selon la revendication 1 dans laquelle les plans sur lesquels sont agencés lesdits résonateurs électromagnétiques de type boucle ouverte forment un angle compris entre 10° et 170°, et de préférence entre 45° et 135°, avec ledit plan contenant les axes longitudinaux des deux résonateurs électromagnétiques linéaires.

**3.** Antenne réseau selon l'une des revendications précédentes dans laquelle ledit dispositif de découplage comprend une pluralité de supports de circuit imprimé planaires (9), sur chacun desquels sont réalisés entre 1 et 6 dits résonateurs de type boucle ouverte.

**4.** Antenne réseau selon l'une des revendications précédentes dans laquelle lesdits résonateurs électromagnétiques de type boucle ouverte sont agencés sur un nombre de plans compris entre 2 et 10 et de préférence entre 3 et 6.

**5.** Antenne réseau selon l'une des revendications précédentes dans laquelle ledit dispositif de découplage comprend un système mécanique de fixation (100) permettant au moins une modification de la géométrie dudit dispositif choisie parmi :

> • un déplacement d'au moins un dit résonateur électromagnétique de type boucle ouverte dans une direction (a1) perpendiculaire aux axes longitudinaux (L) des deux résonateurs électromagnétiques linéaires et gisant dans le plan (pr) contenant ces axes ;
> • une rotation d'au moins un dit résonateur électromagnétique de type boucle ouverte autour d'un axe (a2) parallèle aux axes longitudinaux des deux dits résonateurs électromagnétiques linéaires ; et
> • un déplacement d'au moins un dit résonateur électromagnétique de type boucle ouverte dans son plan, suivant une direction (v) perpendiculaire aux axes longitudinaux des deux dits résonateurs électromagnétiques linéaires.

**6.** Antenne réseau selon la revendication 5 dans laquelle ledit système mécanique de fixation (100) est configuré pour permettre le déplacement ou la rotation d'au moins un dit résonateur électromagnétique de type boucle ouverte indépendamment des autres.

7. Antenne réseau selon l'une des revendications précédentes comprenant également une surface de masse (5) globalement concave par rapport aux deux dits résonateurs électromagnétiques linéaires et obtenue par l'extrusion d'un profil le long de leurs axes longitudinaux.

8. Antenne réseau selon l'une des revendications précédentes dans laquelle ledit dispositif de découplage présente une symétrie par rapport à un plan (ps) perpendiculaire audit plan (pr) contenant les axes longitudinaux des deux résonateurs électromagnétiques linéaires.

9. Antenne réseau selon l'une des revendications précédentes dans laquelle les deux dits résonateurs linéaires sont identiques.

10. Antenne réseau selon l'une des revendications précédentes dans laquelle chaque dit résonateur électromagnétique à boucle ouverte comprend une boucle conductrice interrompue par un condensateur discret (7) ou un élément à capacité répartie (8).

11. Antenne réseau selon l'une des revendications précédentes dans laquelle les deux dits résonateurs électromagnétiques linéaires sont agencés côte à côte, un axe (a1) unissant leurs centres étant perpendiculaire à leurs axes longitudinaux.

12. Antenne réseau selon l'une des revendications 1 à 10 dans laquelle les deux dits résonateurs linéaires sont décalés à la fois suivant une direction parallèle à leurs axes longitudinaux et une direction perpendiculaire auxdits axes.

13. Antenne réseau selon l'une des revendications précédentes comprenant une pluralité de dits résonateurs électromagnétiques linéaires orientés parallèlement les uns aux autres et adjacents deux à deux, un dit dispositif de découplage étant agencé entre chaque paire de résonateurs électromagnétiques linéaires adjacents.

14. Antenne réseau selon la revendication 13 dans laquelle lesdits résonateurs électromagnétiques entourent une cavité (110) permettant l'insertion d'une partie d'un corps humain ou animal.

15. Appareil d'imagerie par résonance magnétique nucléaire comprenant une antenne réseau selon la revendication 14.

**Patentansprüche**

1. Gruppenantenne, die eine Vielzahl von linearen elektromagnetischen Resonatoren (4) mit Längsachsen (L), die parallel zueinander orientiert und nicht auf einer gemeinsamen Achse angeordnet sind, und mindestens eine Entkopplungsvorrichtung (1) umfasst, die zwischen zwei benachbarten linearen elektromagnetischen Resonatoren angeordnet ist, wobei die Entkopplungsvorrichtung eine Vielzahl von elektromagnetischen Resonatoren des Typs mit offener Schleife (3) umfasst, abgestimmt auf eine Frequenz in der Bandbreite der zwei benachbarten linearen elektromagnetischen Resonatoren und elektrisch von ihrer Umgebung isoliert, wobei jeder elektromagnetische Resonator mit offener Schleife eine charakteristische Abmessung derselben Größenordnung hat wie die Länge der beiden benachbarten linearen Resonatoren, **dadurch gekennzeichnet, dass** die Vielzahl von elektromagnetischen Resonatoren des Typs mit offener Schleife in einer Vielzahl von jeweiligen Ebenen (2), die nicht parallel zu einer Ebene (pr) angeordnet sind, die die Längsachsen der beiden benachbarten linearen elektromagnetischen Resonatoren enthält.

2. Gruppenantenne nach Anspruch 1, bei der die Ebenen, auf denen die elektromagnetischen Resonatoren des Typs mit offener Schleife angeordnet sind, einen Winkel zwischen 10° und 170°, und vorzugsweise zwischen 45° und 135°, mit der Ebene bilden, die die Längsachsen der beiden linearen elektromagnetischen Resonatoren enthält.

3. Gruppenantenne nach einem der vorherigen Ansprüche, bei der die Entkopplungsvorrichtung eine Vielzahl von planaren Leiterplattenträgern (9) umfasst, auf denen jeweils 1 bis 6 der Resonatoren des Typs mit offener Schleife realisiert sind.

4. Gruppenantenne nach einem der vorherigen Ansprüche, bei der die elektromagnetischen Resonatoren des Typs mit offener Schleife auf einer Anzahl von 2 bis 10, und vorzugsweise von 3 bis 6 Ebenen angeordnet sind.

5. Gruppenantenne nach einem der vorherigen Ansprüche, bei der die Entkopplungsvorrichtung ein mechanisches Befestigungssystem (100) umfasst, das mindestens eine Modifikation der Geometrie der Vorrichtung zulässt, ausgewählt aus:

   • einer Bewegung von mindestens einem elektromagnetischen Resonator des Typs mit offener Schleife in einer Richtung (a1) senkrecht zu den Längsachsen (L) der beiden linearen elektromagnetischen Resonatoren, die in der Ebene (pr) liegen, die diese Achsen enthält;

• einer Rotation von mindestens einem elektromagnetischen Resonator des Typs mit offener Schleife um eine Achse (a2) parallel zu den Längsachsen der beiden linearen elektromagnetischen Resonatoren; und
• einer Bewegung von mindestens einem elektromagnetischen Resonator des Typs mit offener Schleife in seiner Ebene in einer Richtung (v) senkrecht zu den Längsachsen der beiden linearen elektromagnetischen Resonatoren.

6.  Gruppenantenne nach Anspruch 5, bei der das mechanische Befestigungssystem (100) so konfiguriert ist, dass es die Bewegung oder die Rotation von mindestens einem elektromagnetischen Resonator des Typs mit offener Schleife unabhängig von den anderen zulässt.

7.  Gruppenantenne nach einem der vorherigen Ansprüche, die auch eine Massefläche (5) umfasst, die global konkav in Bezug auf die beiden linearen elektromagnetischen Resonatoren ist und durch Extrusion eines Profils entlang ihrer Längsachsen erhalten wird.

8.  Gruppenantenne nach einem der vorherigen Ansprüche, bei der die Entkopplungsvorrichtung eine Symmetrie in Bezug auf eine Ebene (ps) senkrecht zu der Ebene (pr) aufweist, die die Längsachsen der beiden linearen elektromagnetischen Resonatoren enthält.

9.  Gruppenantenne nach einem der vorherigen Ansprüche, bei der die beiden linearen Resonatoren identisch sind.

10. Gruppenantenne nach einem der vorherigen Ansprüche, bei der jeder elektromagnetische Resonator mit offener Schleife eine leitfähige Schleife umfasst, unterbrochen durch einen diskreten Kondensator (7) oder ein Element mit verteilter Kapazität (8).

11. Gruppenantenne nach einem der vorherigen Ansprüche, bei der die beiden linearen elektromagnetischen Resonatoren Seite an Seite angeordnet sind, wobei eine Achse (a1), die ihre Mittelpunkte vereinigt, senkrecht zu ihren Längsachsen ist.

12. Gruppenantenne nach einem der Ansprüche 1 bis 10, bei der die beiden linearen Resonatoren gleichzeitig in einer Richtung parallel zu ihren Längsachsen und einer Richtung senkrecht zu den Achsen versetzt sind.

13. Gruppenantenne nach einem der vorherigen Ansprüche, die eine Vielzahl von linearen elektromagnetischen Resonatoren umfasst, die parallel zueinander und paarweise nebeneinander orientiert sind, wobei eine Entkopplungsvorrichtung zwischen jedem Paar von benachbarten linearen elektromagnetischen Resonatoren angeordnet ist.

14. Gruppenantenne nach Anspruch 13, bei der die elektromagnetischen Resonatoren einen Hohlraum (110) umgeben, der das Einfügen eines Teils eines menschlichen oder tierischen Körpers zulässt.

15. Kernspinresonanz-Bildgebungsgerät mit einer Gruppenantenne nach Anspruch 14.

## Claims

1.  An antenna array comprising a plurality of linear electromagnetic resonators (4) having longitudinal axes (L) oriented parallel to one another and not placed on a common axis, and at least one decoupling device (1) arranged between two said adjacent linear electromagnetic resonators, said decoupling device comprising a plurality of open-loop electromagnetic resonators (3) that are matched to a frequency located in the bandwidth of the two said adjacent linear electromagnetic resonators, that are electrically insulated from their environment, each said open-loop electromagnetic resonator having a characteristic dimension of the same order of magnitude as the length of the two said adjacent linear resonators, **characterized in that** the plurality of open-loop electromagnetic resonators are arranged in a plurality of respective planes (2) that are not parallel to a plane (pr) containing the longitudinal axes of the two said adjacent linear electromagnetic resonators.

2.  The antenna array according to claim 1, wherein the planes in which said open-loop electromagnetic resonators are arranged make an angle comprised between 10° and 170°, and preferably between 45° and 135°, to said plane containing the longitudinal axes of the two linear electromagnetic resonators.

3.  The antenna array according to one of the preceding claims, wherein said decoupling device comprises a plurality of planar printed-circuit-board carriers (9), on each of which are produced between 1 and 6 said open-loop resonators.

4.  The antenna array according to one of the preceding claims, wherein said open-loop electromagnetic resonators are arranged in a number of planes comprised between 2 and 10 and preferably between 3 and 6.

5.  The antenna array according to one of the preceding claims, wherein said decoupling device comprises a mechanical fastening system (100) allowing at least one modification of the geometry of said device, being chosen from:

• a movement of at least one said open-loop electromagnetic resonator in a direction (a1) perpendicular to the longitudinal axes (L) of the two linear electromagnetic resonators and lying in the plane (pr) containing these axes;
• a rotation of at least one said open-loop electromagnetic resonator about an axis (a2) parallel to the longitudinal axes of the two said linear electromagnetic resonators; and
• a movement of at least one said open-loop electromagnetic resonator in its plane, in a direction (v) perpendicular to the longitudinal axes of the two said linear electromagnetic resonators.

6. The antenna array according to claim 5, wherein said mechanical fastening system (100) is configured to allow at least one said open-loop electromagnetic resonator to be moved or rotated independently of the others.

7. The antenna array according to one of the preceding claims, also comprising a ground plane (5) that on the whole is concave with respect to the two said linear electromagnetic resonators and obtained by extruding a profile along their longitudinal axes.

8. The antenna array according to one of the preceding claims, wherein said decoupling device has a symmetry with respect to a plane (ps) perpendicular to said plane (pr) containing the longitudinal axes of the two linear electromagnetic resonators.

9. The antenna array according to one of the preceding claims, wherein the two said linear resonators are identical.

10. The antenna array according to one of the preceding claims, wherein each said open-loop electromagnetic resonator comprises a conductive loop interrupted by a discrete capacitor (7) or a distributed capacitive element (8).

11. The antenna array according to one of the preceding claims, wherein the two said linear electromagnetic resonators are arranged side-by-side, an axis (a1) joining their centers being perpendicular to their longitudinal axes.

12. The antenna array according to one of claims 1 to 10, wherein the two said linear resonators are shifted both in a direction parallel to their longitudinal axes and in a direction perpendicular to said axes.

13. The antenna array according to one of the preceding claims, comprising a plurality of said linear electromagnetic resonators oriented parallel to one another and adjacent pairwise, a said decoupling device being arranged between each pair of adjacent linear electromagnetic resonators.

14. The antenna array according to claim 13, wherein said electromagnetic resonators encircle a cavity (110) allowing a part of an animal or human body to be inserted.

15. A nuclear magnetic resonance imaging apparatus comprising an antenna array according to claim 14.

FIG.1a    FIG.1b    FIG.1c

FIG.1d    FIG.1e

FIG.2

FIG.3a

FIG.3b

FIG.3c

FIG.3d

FIG.3e

FIG.4a

FIG.4b

FIG.5a

FIG.5b

FIG.6

FIG.7

FIG.8a

FIG.8b

FIG.9

FIG.10

FIG.11

FIG.12

|  | Seul | Sans 1 | Avec 1 | α (°) |
| --- | --- | --- | --- | --- |

Dipôle 41 — (a) (b) (c)

Dipôle 42 — (d) (e) (f)

FIG.13

FIG.14

FIG.15

FIG.16

FIG.17

EP 3 400 454 B1

FIG.18a

FIG.18b

FIG.19

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130271144 A1, Avdievich, N. I.
- US 20110312499 A1, Vaughan, J. T.
- WO 2011098713 A1, Ferrand, G.
- WO 2014109757 A1, Menon R.

- EP 1269211 B1, Young I.R.
- US 20110121834 A1, Y. Soutome
- EP 2757385 A1, R. Yeun-chul


**Littérature non-brevet citée dans la description**

- **LEE, R. F. et al.** Coupling and decoupling theory and its application to the MRI phased array. *Magnetic Resonance Medicine,* 2002, vol. 48, 203-213
- **YAN, X. ; ZHANG, X.** Decoupling and matching network for monopole antenna arrays in ultrahigh field MRI. *Quantitative imaging in medicine and surgery,* 2015, vol. 5 (4), 546-551
- **FERRER, P. J. et al.** Decorrelation of two closely spaced antennas with a metamaterial AMC surface. *Microwave and optical technology letters,* 2008, vol. 50 (5), 1414-1417

- **CONNEL I. R. O. et al.** MRI RF Array Decoupling Method With Magnetic Wall Distributed Filters. *IEEE Transactions on Medical Imaging,* 2015, vol. 34 (4), 825-835
- **CONNEL I. R. O. et al.** Design of a Parallel Transmit Head Coil at 7T With Magnetic Wall Distributed Filters. *IEEE Transactions on Médical Imaging,* 2015, vol. 34 (4), 836-865
- **Y. SOUTOME et al.** Vertical Loop Decoupling Method for Gapped Phased-Array Coils. *Proc. Intl. Soc. Mag. Reson. Med.,* 2011, vol. 19, 1859